Europäisches Patentamt

**European Patent Office**

**Office européen des brevets**

(11) Publication number: **0 098 780**

**A2**

(12) **EUROPEAN PATENT APPLICATION**

(21) Application number: **83401359.1**

(22) Date of filing: **01.07.83**

(51) Int. Cl.³: **G 01 R 5/06**

(30) Priority: **09.07.82 US 396586**
**09.07.82 US 396587**
**09.07.82 US 396588**

(43) Date of publication of application: **18.01.84**
**Bulletin 84/3**

(84) Designated Contracting States: **DE FR GB IT NL**

(71) Applicant: **SANGAMO WESTON, INC., 180 Technology Drive, Norcross Georgia 30092 (US)**

(72) Inventor: **Nador, Julius, P.O. Box 29, Blairstown New Jersey 07825 (US)**

(74) Representative: **Chareyron, Lucien et al, Schlumberger Limited 42, rue Saint-Dominique, F-75340 Paris Cedex 07 (FR)**

(54) **Analog panel meter mechanism.**

㊙ An electrical meter comprising a moving coil (10) on a flangeless support mean, a hub (14), a balance cross and taut band assembly (16), bridge structure (82) and permanent magnet assembly (60) with two pole pieces (62) and a magnet (70) and support plates (66, 68).

EP 0 098 780 A2

ANALOG PANEL METER MECHANISM

Background of the Invention

This invention relates to electrical measurement devices of the moving coil, permanent magnet type.

Moving coil permanent magnet electrical meter mechanisms are known in the prior art, as illustrated by U.S. Pat. Nos. 4,024,472, 3,490,043, 3,005,952 and 3,551,812.

Such devices comprise many small, precisely machined or formed parts. Assembly of these prior art devices typically requires several manual insertion or alignment steps which are labor intensive and obviously increases the cost of manufacture.

Moreover, the components such as coil frame and the permanent magnet are complicated and expensive to manufacture, as in U.S. Pat. No. 3,055,182 where the coil frame includes typical coil retaining flanges, mounting tabs, etc., and in U.S. Pat. Nos. 3,005,952 and 4,024,472 where the magnet is manufactured by a cold pressing process. Assembly of the prior art meters further requires movement of a subassembly in one direction, to combine with an additional component, followed by movement of the resulting combination in an opposite direction. Such back-and-forth precise manipulation of the various subassemblies is time consumptive, labor intensive and thus expensive.

In taut band suspensions for electrical meters, and particularly for those subject to mechanical stress, damping devices are preferred to restrain vibration induced in the moving coil assembly through the suspension. The use of a viscous liquid, specifically oil, to provide such damping is described in U.S. Pat. No. 3,439,273 and in a publication of Crompton Instruments, U/S 700, June 1974, pages 5 and 6. The prior art use of oil damping, however, requires the use of additional structural components and to keep the damping oil in place, thus adding to the expense of producing the meter. Specifically, closed cell foamed plastic pads are required. The prior art does not suggest the use of oil damping without such expensive structural modifications of a meter mechanism.

In the past, it has been the practice to use magnets formed of alloys of cobalt, an expensive material. Meter mechanisms using more readily available and less expensive ceramic magnets have not found widespread use because of high temperature variation in operating characteristics. One illustration of the use of a ceramic magnet in a meter mechanism is described in U.S. Pat. No. 3,490,043. However, this reference fails to disclose any method or apparatus for compensation of the temperature variable characteristics of the magnet.

As described by Parker and Studders, in Permanent Magnets and Their Application, John Wiley and Sons, Inc., 1962, ceramic magnets exhibit a temperature coefficient of approximately -0.2 remanence change per degree centigrade from room temperature, while various Alnico materials have such coefficients which are typically in the range of -.02 to +.01 percent. Thus, although the base materials for ceramic magnets are inexpensive and plentiful, and are not strategic materials, Alnico magnets (which use up to 36 percent cobalt) are clearly superior in temperature stability.

Two methods are known for compensation of the large temperature coeffecient of ceramic magnets. One such method relies on the use of oversaturated pole pieces in conjunction with the ceramic magnet. This is, the magnetic field includes more magnetic flux than can be concentrated by the pole piece. If sufficient margin is provided above the saturation level for the pole piece, a reduction in the magnetic flux density due to temperature increases may leave the air gap flux density unaffected since the pole piece remains at or above its saturation level.

However, this approach prohibits the use of the standard charging and treating calibration procedure for the meter mechanism. In the charging and treating method, the permanent magnet is initially charged to a higher flux density than required to achieve the needed sensitivity. In a subsequent treating step, the magnetization level is reduced, to lower the sensitivity to the desired calibrated value.

Where the excessive flux density is relied upon for compensation of the magnet's high temperature coefficient of remanence change, it is apparent that the charging and treating method affects the degree of temperature compensation. Accordingly, the method of "oversaturation" of the pole piece requires the use of an expensive calibration technique for the meter mechanism, in which a separate conductivity shunt is required to be selected, soldered in place and adjusted to bypass a fraction of the meter current. The prior art has thus avoided the use of ceramic permanent magnets for moving coil meter mechanisms, because of both the high temperature variability and the difficulty of sensitivity calibration of temperature compensated mechanisms.

In a second compensation method, a special nickel-iron alloy shunt is used to divert a portion of the flux density from the air gap, the diverted portion decreasing with increasing temperature. This approach is described in Parker et al for a drag device such as a watt-hour meter. No such compensation is available in the prior art, however, for a moving coil permanent magnet type of meter.


SUMMARY OF THE INVENTION

It is a general object of the present invention to provide an improved method and apparatus for measuring electrical quantities.

This and other objects are attained, in accordance with one aspect of the invention by a moving coil permanent magnet mechanism for measuring electrical quantities, comprising a moving coil wound about a flangeless support means; a balance cross structure for providing balanced support for a pointer; hub means for engaging said balance cross structure to said support means, said hub means including longitudinal indentations for engaging edges of a surface of said support means; and extension portions dimensioned to prevent relative longitudinal movement between said hub means and said support means; and torsional spring means connected to said balance cross structure for suspending an assembly of said hub means, said balance cross structure, and said support means.

Another aspect includes a mechanism having two relatively movable assemblies for metering electrical parameters, wherein a first assembly is connected to a second assembly by a torsional suspension means, said second assembly having a component rotationally movable with reference to said first assembly, comprising viscous damping means for control of mechanical vibrations between said first and second assemblies, including a damping control area, defined by a predetermined portion of said component of said second assembly; a viscous liquid contacting said predetermined portion of said component defining said damping control area; and anti-wetting means provided on further portions of said component for retaining said viscous liquid in contact with, and preventing its spread from, said damping control area.

A further aspect is attained by a method for temperature compensation of the permanent magnet of a moving coil meter mechanism having a permanent magnet, pole pieces arranged for forming a housing for said permanent magnet, a yoke structure, and a wound coil movable in an air gap formed between the pole pieces and the yoke structure, said method comprising the steps of (a) determining a magnetic flux density to be established within said air gap for linking said movable wound coil; (b) establishing limits for acceptable variation of said flux density within said air gap for a predetermined temperature range; and (c) reducing variations in said flux density within said air gap to be within the established limits for the predetermined temperature range, including the step of placing an appropriately dimensioned compensating shunt, formed of material having a temperature dependent permeability, adjacent and parallel to said permanent magnet.

Yet another aspect includes a moving coil meter mechanism having a permanent magnet, pole pieces arranged for forming a housing for said permanent magnet, a yoke structure and a wound coil movable in an air gap formed between the pole pieces and the yoke structure, the meter mechanism including means for providing compensation for variations in flux density within said air gap caused by temperature changes, comprising compensating shunt means formed of material having a temperature variable permeability, said compensating shunt means being positioned adjacent and parallel to said permanent magnet and having a thickness selected for reducing the temperature caused variations in flux density within said air gap to predetermined acceptable limits.

## Brief Description of the Drawing

These and other objects and features of the present invention will become more readily apparent to those skilled in the art from the following description when read in conjunction with the accompanying drawing figures, wherein:

Figure 1 shows an exploded assembly view of a meter mechanism according to the present invention;

Figure 2 illustrates the individual components used to form the assemblies of Figure 1, both in exploded and subassembled form;

Figures 3A and 3B show details of a hub component of the inventive mechanism in plan and side views, respectively; and

Figure 4 shows a bottom view of a top bridge component for the inventive mechanism; and

Figures 5A, B, and C show various configurations of a viscous damping system in accordance with the invention.

## Best Mode for Carrying Out the Invention

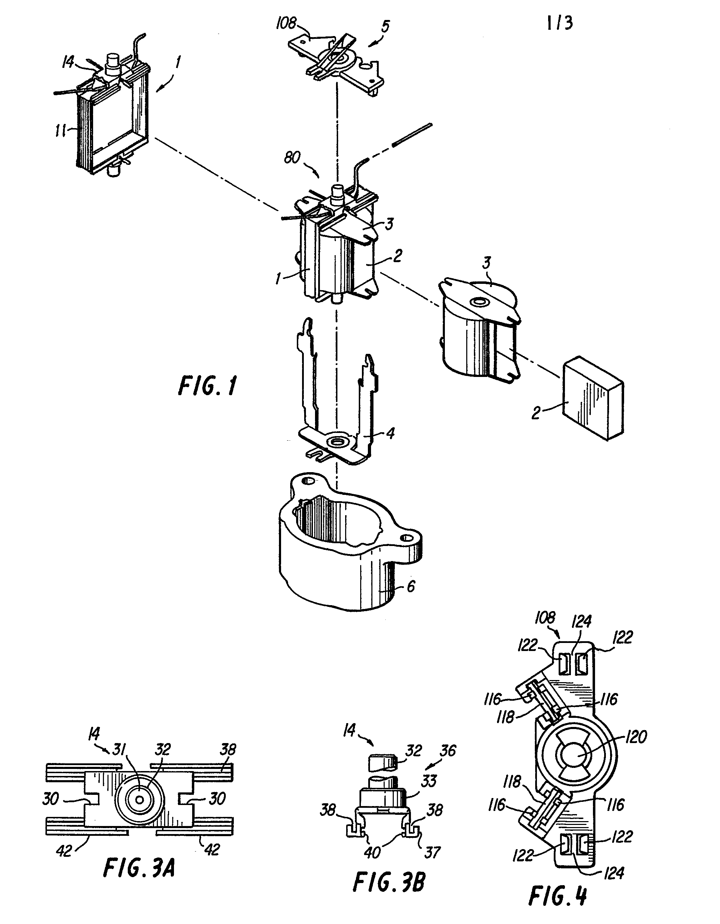

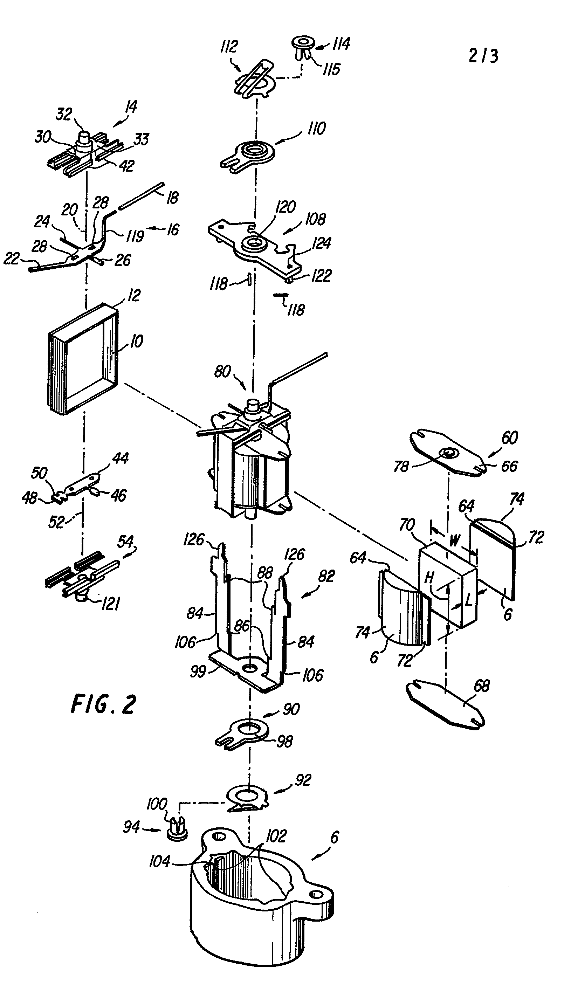

An improved moving coil permanent magnet meter mechanism according to the present invention is shown in Fig. 1 and includes a moving coil and rotor assembly 1, a permanent magnet 2, a housing assembly 3 therefor, a U-shaped bottom bridge support assembly 4, a top bridge assembly 5, and a yoke 6.

As will be appreciated, the several assemblies cooperate to provide angular rotation of moving coil assembly 1 and a deflection of a pointer attached thereto in response to the flow of current through the coil of assembly 1. When assembled, permanent magnet 2 is located within housing 3, and coil and rotor assembly 1 surrounds housing 3. The several assemblies are supported by bottom support assembly 4 and capped by top bridge assembly 5. This supported and capped assembly is mounted within yoke 6, such that the wound coil of assembly 1 is within an annular air gap defined between housing 3 and yoke 6. Magnet 2 generates a magnetic field in the air gap between pole pieces of its housing 3 and yoke 6, and the magnetic field generated by current flow through the winding of coil assembly 1 provides a torque operative to rotate the coil and pointer to a position of equilibrium with the developed torque in the torsional spring (taut band).

Referring to Figure 2, the coil and rotor assembly 1 is shown as including a flangeless moving coil frame 10. For economy and ease of manufacture, coil frame 10 is provided as a simple extruded component, without locating tabs, protrusions, indents, or the like. The coil frame is formed by slicing a rectangular extrusion at appropriate intervals to provide a plurality of inexpensive coil frames of appropriate thicknesses.

A wire winding 12 is provided on coil frame 10. Preferably an adhesively coated wire is wound around the coil frame. Wire 12 may be heated after winding on frame 10 to activate the adhesive, thereby causing the various windings to adhere both to each other and to the frame itself. As a result, an integrated and strengthened rotor subassembly results.

Wire 12 is not wound along the entire width of the surface of coil frame 10, however. Rather, a margin 11 is left along the edges of the frame surfaces to enable clamping engagement of a plastic hub 14 thereto. A balance cross and taut band assembly 16 is provided for mounting a pointer 18 to indicate the electrical quantity being measured. A taut band 20 is attached to balance cross assembly 16, preferably by welding the band to the underside thereof.

A tail section 22 and a side section 24 are provided for static balancing of balance cross assembly 16. Ballast weight may be added to the tail and side sections, as needed, by winding a number of turns of wire thereon. A terminating loop 26 of conductive material is provided on the balance cross for one end of moving coil wire 12, while taut band 20 is used to provide external contact to loop 26, and hence to wire 12. The entire balance cross assembly may be conductive, or only the terminating loop may be conductive.

A pair of upstanding tabs 28 are provided on the central portion of assembly 16 for engaging corresponding notches 30 in the central portion of hub 14. Accordingly, hub 14 is mounted on balance cross assembly 16 by insertion of taut band 20 through an opening 31 in a central tower 32 thereof. Tabs 28 engage notches 30 and are bent over a horizontal base section 33 of hub 14 in order firmly to engage the two components together. See Fig. 3A for example.

Hub 14 is further provided with an assembly aid 36, as shown in detailed Figure 3B. The assembly aid comprises depending skirt portions 37, which include a pair of channels 38 provided therein for engagement by a spreading tool in order to mount the assembled hub and balance cross on coil frame 10. Further, for engaging the margins of coil frame 10, additional rails 40 are provided on the inner surfaces of assembly aid 36. Accordingly, when the combined hub and balance cross assembly is engaged by a spreading tool at channels 38, depending skirt portions 37 are spread so that the assembly may be mounted on coil frame 10. In order to secure the assembly to the coil frame, rails 40 engage the margin edges of the coil frame.

Hub 14 also includes extension sections 42, shown in Figure 3A and in Figure 2, appropriately dimensioned to match the inner dimension of the coil frame, which act to self-center the hub directly on the coil frame and to prevent longitudinal movement thereof.

As will be appreciated by those skilled in the art, the above-described structure enables a simple, quick, and automated assembly of its several components when compared to prior art devices having flanged moving coil frames with tabs thereon for engaging a balance cross or similar component.

While such prior art devices require the balance cross to be manually positioned on the coil frame, for example, and further require manual positioning of the coil frame tabs, the above-described features of the present invention enable automated assembly of its various components.

The rotor assembly including the moving coil is completed by engagement of a lower portion which, similarly to the balance cross of the upper portion, includes a counterbalance arm 44. The counterbalance arm includes a terminal 46 for connection to the other end of moving coil wire 12, and a counterbalance 48 in which a number of notches 50 are provided. The appropriate number of notches is determined in order properly to counterbalance the weight of pointer 18 mounted on balance cross assembly 16. A number of turns of wire may be wound on terminal 46 to provide appropriate weight balancing. Further, a second taut band portion 52 of the taut band suspension is provided for counterbalance arm 44, and is preferably welded to the upper surface of arm 44. A second hub 54, substantially identical with hub 14, is provided. Taut band portions 20 and 52 provide both a torsion spring for the moving coil assembly and contacts to wire winding 12.

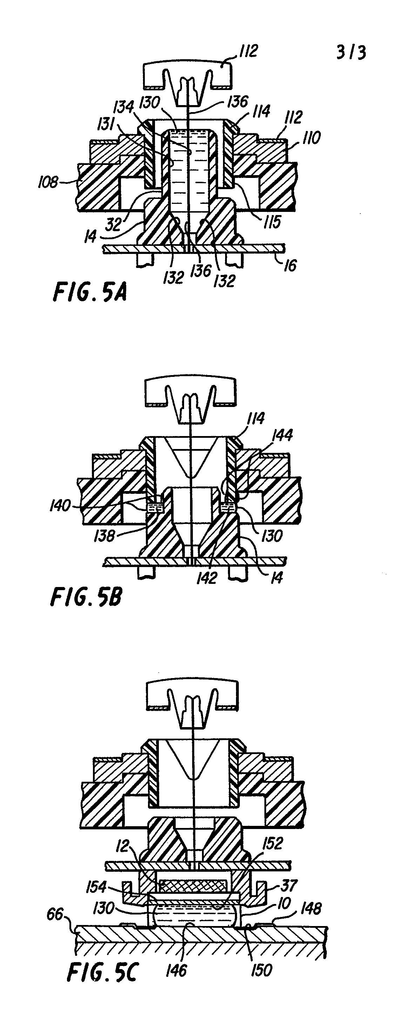

Portion 52 protrudes through a central opening in a central tower of hub 54, and assembly aids and engagement structure similar to that of hub 14 are provided for mounting hub 54 and counterbalance arm 44 on coil frame 10. Relative movement between the taut band and the hub 14 is damped by the use of a viscous oil, as described below with reference to Figures 5A-5C.

A permanent magnet assembly 60, shown at 2 and 3 in Figure 1, includes a pair of pole pieces 62 as seen in Figure 2. The pole pieces are formed of high purity soft iron in order to provide sufficiently high permeability for the intended use. The upper and lower surfaces of the pole pieces are provided with steps, such as illustrated at 64 for the upper surfaces, for accepting a pair of elongated, notched upper and lower support plates 66 and 68 between the pole pieces, thus forming a cage for a magnet 70. The support pieces rest on the lower horizontal surfaces of steps 64, and rigidly separate the vertical surfaces of the steps. The magnet subassembly is formed by welding of the upper support plate 66, and lower support plate 68, to the appropriate positions between the steps 64 of the pole pieces 62. This approach is more cost effective than the prior art approach of cementing or soldering of the magnet 70 to one of the pole pieces.

Pole pieces 62 are provided with lips 72, in order to enable the use of a larger magnet and so to provide increased meter sensitivity and more efficient operation. Lips 72 act as collectors for additional flux introduced by the magnet. The pole pieces are further provided with arcuate portions 74 for concentrating the magnetic flux within the air gap formed within yoke 6. As described below with reference to Figures 5A-5C, the upper and lower support plates 66 and 68 are each provided with a central area 78, shown as having an annular portion coined into the surfaces thereof. This area is used in combination with an anti-wetting agent to define the shape of a drop of viscous fluid, such as silicon oil, used to provide viscous damping for the moving coil. A similar offset may be provided in the underside of frame 10 for shaping the oil drop. Such viscous damping is particularly helpful in environments wherein the meter movement is subject to vibrations and other similar mechanical stresses.

In accordance with an important feature of the invention, at least one of the support plates 66 and 68 is used as a temperature compensating shunt for permanent magnet 70 which preferably is formed from a magnetic ceramic material, such as barium ferrite. Such compensation is based upon the use of a permeable material, such as nickel-iron alloy, of appropriate dimensions to operate in a saturated state in the air gap. Accordingly, air gap flux variations which would otherwise result due to temperature-induced changes in operating characteristics of the permanent magnet may be compensated for.

Ceramic magnet 70 is shaped to high precision by regrinding (e.g. with a diamond wheel) to have plane parallel surfaces, a process which is more economical than that used to form Alnico magnets, which typically are made by cold forging of a powder in a die.

The dimensions of magnets are chosen to provide the maximum energy product for a normal demagnetization curve. Such curves are published for specific magnet materials, and an operating point is determined by knowledge of the permeance coefficient (B/H) for the specific magnet. As is known in the art, the permeance coefficient is a function of the dimensions of the magnet. For a rectangular ceramic magnet the permeance coefficient is calculated as follows:

$$B/H = \frac{1.77L}{(W)\,(H)}\sqrt{L\ (W+H)\ (W \cdot H)}$$

where L is the magnet's length in the direction of magnetization, W is the magnet's width, H is the height of the magnet and dimensions are in inches.

From the published demagnetization curves and energy product curves, an ideal B/H coefficient is determined. For example, in one actual sample manufactured in accordance with the present invention, L was set to .230", W was set to .567", and H was set to .640". Thus

$$B/H = \frac{(1.77)(.230)}{(.567)(.640)} \sqrt{(.230)(.567 + .640) + (.567)(.640)}$$

$$= .90$$

Different dimensions may be used in the equation to obtain a permeance closest to the ideal value.

From the actual permeance, the magnet's induction and demagnetizing force (B,H) may be determined. The magnet's temperature coefficient is known (typically -0.19 percent/degree centigrade for barium ferrite magnets). For operation in a desired temperature range, the change in flux density may be determined by multiplying the temperature range (in degrees centigrade) by the temperature coefficient to obtain an expected percentage change in the flux density for the particular temperature range. Multiplication of the normal flux density determined from the demagnetization curve for the particular permeance of the magnet by the determined percentage change in flux density yields the total flux density change, in gauss per square centimeter, for example, in the magnet over the predetermined temperature range.

It is this change in flux density which is to be compensated by the shunt. As described at pages 350-355 in Parker and Studders, the number of flux lines in the shunt at a particular temperature is linearly proportional to the permeability of the material at that temperature and the cross-sectional area of the shunt. Since the permeability of the material changes (decreases) with increasing temperature, it is apparent that the shunt flux decreases with increasing temperature. Inasmuch as the magnet's flux density similarly decreases with temperature, it is seen that for an appropriate cross-sectional area, the shunt diverts an appropriately decreasing portion of the magnets flux from the air gap, thereby providing a substantially constant flux (subject to over- or under-compensation) within the air gap. The cross-sectional area of the shunt is thus determined from the equation $\bar{\Phi} = 46\mu A$, where $\mu$ is the permeability and A the cross-sectional area of the shunt, and $\bar{\Phi}$ the shunt flux.

Knowing the flux density to be compensated by the shunt, the number of flux lines required to pass through the shunt are determined by multiplying the flux density change by the magnet area, and the appropriate cross-sectional area of the shunt is thus determined. From a knowledge of the cross-sectional area of the shunt and the width thereof (equal to the magnet width), the thickness of the shunt is thus determined. A number of shunts may be combined to provide a combined thickness equal to the calculated value to provide the desired temperature shunting. Thus one or both of support plates 66 and 68, having the appropriate combined thickness, may be used to provide the temperature compensation for magnet 70.

In one example, an Index 8 ceramic magnet having dimensions L = 0.230", W = 0.567" and H = 0.640" was required to operate over a temperature range of $120^{\circ}C$ about a nominal temperature of $25^{\circ}C$. For the magnet dimensions, B/H = 0.9, and at $25^{\circ}C$ normal B(Index) = 1,700 gauss/cm$^2$ and H = 1,900 oersted. With a magnet temperature coefficient of −0.19 %/$^{\circ}C$, B = 1,700 x 20 x 0.19% = 64.6 gauss/cm$^2$. For the magnet dimensions, $\bar{\Phi}$ = (65)(2.3413) = 152 flux lines. The cross-sectional area of the shunt is determined from A = $\bar{\Phi}$/(46)($\mu$). Finally, a shunt having the appropriate thickness was used to determine the remaining, uncompensated error. Using the previously calculated shunt thickness and the corrected deviation, the total thickness for correcting the total flux line deviation was calculated to be 0.055". Using a pair of shunts having a total thickness of 0.057", one unit displayed −0.3% maximum error at $5^{\circ}C$ and −0.6%

maximum error at 45$^{\circ}$C, thus showing a slight degree of over-compensation.  A small reduction in compensator thickness would reduce the observed maximum error still further.

Typical compensating alloy materials are 30-32% nickel-iron alloys, sometimes referred to as Curie alloys.

Thus, use of the above-described compensation shunt permits use of inexpensive and readily available ceramic magnets, made of barium ferrite, for example, instead of the more stable but more expensive alloys of cobalt.  Such magnets have not found previous use in the moving coil type of meter mechanism because such magnets were previously designed having difficult to machine shapes, because of the unacceptably high temperature variation in their characteristics, and further because previous compensation of temperature variations required the use of expensive sensitivity calibration techniques.  By utilizing the type of ceramic magnet described, shunt temperature compensation as well as charge-and-treat calibration techniques may be used, in combination with an inexpensive parallel face diamond wheel grinding technique.  The present invention thus overcomes the drawbacks previously associated with the use of these inexpensive magnets.

A bridge assembly is provided for retaining magnet assembly 60 and moving coil assembly 1 within yoke 6.  To assemble the complete structure, magnet assembly 60 is inserted into the moving coil assembly, comprised of frame 10, balance cross 16 and counterbalance arm 44 and the upper and lower hubs 14 and 54.  The combined moving coil and magnet assembly, shown at 80 in Figures 1 and 2, is inserted into the bottom support assembly 4 of Figure 1.  The bottom support assembly includes a bottom bridge structure 82, which comprises a U-shaped element having a pair of upstanding arms 84.  Each arm 84 includes a lip 86 providing a rest for bottom support plate 68 of magnet assembly 60.  A pair of locking tabs 88 are provided for passage through a pair of side notches in upper support plate 66. Once assembled, tabs 88 are bent inwardly (towards each other), thereby vertically locking the magnet assembly between tabs 88 and 86 of bottom bridge structure 82. The inner edges of arms 84 engage the notches of support plates 66 and 68 to lock magnet assembly 60 against rotary or horizontal movement relative to the bottom bridge.

The bottom support assembly further comprises an abutment 90, a tension spring 92, and a retainer 94. Abutment 90 is used for rearward zeroing of the meter movement. The abutment includes a recessed central portion, shown at 98, having an indented upset for receiving a mating central offset portion at a bottom cross segment 99 of bottom bridge structure 82. These two surfaces provide mating bearing and centering surfaces for operation of zeroing abutment 90. Retainer 94, preferably formed from plastic with a split vertical central portion 100, is inserted through an opening in tension spring 92, through a central opening in recessed portion 98 of abutment 90, and through a central opening 101 in the offset portion at the bottom cross 99 of bridge structure 82. The vertical portion 100 of the plastic retainer snaps into position within central opening 101 of bottom bridge 82, thereby to lock together the bottom support assembly 4.

The assembled combination of moving coil and magnet assembly 80 and bottom support assembly 4 is inserted into yoke 6, which is provided with a pair of grooves 102 for receiving the outer edges of arms 84. Positioning shoulders 104 are provided at the upper end of each of the two grooves 102 for location of the magnetic cage thereagainst. Shoulders 104 provide a rest for the elongated extensions of the upper support plate 66. Having been inserted into yoke 6, and being located thereagainst by the support plate 66 and the positioning shoulders 104, the assembled combination of 4 and 80 is fixed within the yoke by staking a pair of shoulders 106, formed along arms 84 of bottom bridge structure 82, against the bottom surface of yoke 6.

A top bridge 108, shown in detail at Figure 4, is combined with an abutment 110 and a tension spring 112, with the combination fastened together by a second split plastic retaining clamp 114, having a central split vertical portion 115, to form top bridge assembly 5. Abutment 110 provides a frontally located adjustment for the rest position of the meter mechanism. As shown in Figure 4, four pairs of fingers 116 are provided at the bottom of top bridge 108 for retaining a pair of beads 118 which are used as deflection limiting bumpers for the moving coil assembly. The beads are preferably formed of ceramic material, having a low surface tension against other materials, and are dimensioned to provide a snapfit with the fingers 116. Top bridge 108 is the insulated side of the mechanism, and is preferably formed of plastic or other insulating materials.

The combined top bridge assembly 5 is mounted to hub 14 of moving coil and magnet assembly 80. When so mounted, beads 118 form horizontal bumpers for a vertical portion 119 of balance cross assembly 16, thereby providing maximum and minimum deflection limits for the moving coil element of the mechanism.

Tower 32 on hub 14 projects through a central opening 120 within top bridge 108, and into vertical portion 115 of retainer 114, thereby limiting lateral movement of the moving coil and magnet assemblies in the event of vibration to the available radial clearance for tower 32. A shoulder of the horizontal portion 33 of the hub cooperates with the bottom surface of central portion 115 of retainer 114 to limit relative vertical movement between the moving coil and magnet assemblies. A similar arrangement is provided for a bottom tower 121 in bottom hub 54 with respect to central portion 100 of retainer 94.

The offset central portions of abutments 98 and 110 are staked to retain tension springs 92 and 112, respectively. These springs are thus free to rotate on the offset bearing surfaces of the abutments. Tension springs 92 and 112 receive taut band portions 52 and 20, respectively. Rotation of the springs, such as by adjustment of abutments 98 and/or 110, is used to set the moving coil to an appropriate initial position.

Top bridge 108 is provided with pairs of depending parallel plates 122, on either side thereof, formed below openings 124. Bottom bridge structure 82 is provided with a pair of arms 126, which are designed to pass through parallel plates 122 and engage openings 124 of top bridge 108. Upon assembly of the top bridge assembly to the bottom bridge assembly within yoke 6, arms 126 are bent outwardly in order to lock the top and bottom bridge assemblies together and to complete the assembly of the meter mechanism.

As will be appreciated, the above-described structure permits automated assembly of the moving coil assembly, the magnet assembly, the bottom support assembly and the upper bridge assembly. By continuous movement in a single direction, moving coil and magnet assembly 80 may be assembled to bottom support assembly 4. Continuing assembly by movement in the same direction, top bridge assembly 5 is assembled to the bottom support assembly. The assembled components are inserted in yoke 6, again requiring movement only in the same direction previously provided, before or after combining assemblies 80 and 4, or after combining all of assemblies 80, 4 and 5.

Three embodiments of the inventive viscous damping structure for an electrical meter are shown in detail at Figures 5A, 5B and 5C.

As shown in Figures 5A and 5B, for example, the inventive structure includes top bridge element 108, fixedly connected to the magnet assembly 60 by top bridge assembly 5 as previously described; and hub 14, attached to the moving coil assembly 1. As shown in detail, retainer 114 clamps abutment 110 to top bridge element 108. The central vertical portion 115 of retainer 114 cooperates with the central tower 32 of hub 14 to limit vertical and lateral motion between the permanent magnet and moving coil assemblies.

The two assemblies are connected by a taut band 20, connected at one of its ends to tension spring 112 and at its other end to balance cross 16.

In order to control the mechanical vibration which may exist between the two assemblies, a viscous liquid 130, such as a silicon oil, for example, is provided within a predetermined portion 131 of central tower 32 of hub 14. Further portions 132 of the interior surface of hub 14 are coated with an anti-wetting agent in order to prevent spread of liquid 130 from the damping control area formed by predetermined portion 131 of hub 14. A typical anti-wetting agent may be obtained from the 3M Company under the trade name FLUORAD, designated by FC-721. A segment 134 of taut band 20 is included in the damping control area and helps define the same. Other portions of taut band 20, shown at 136 may similarly be coated with an anti-wetting agent in order to prevent spread of the viscous liquid and further to assure its containment within the damping control area.

As will be apparent upon reference to Figure 5B, other portions of the hub component of the moving coil assembly may be used to define the damping control area. For example, shoulder surface 138 formed in the horizontal section 33 of hub 14 may define the damping control area. A drop of viscous damping liquid 130 is retained within the damping control area by provision of the anti-wetting agent at further portions 140 of the hub.

In the embodiment of Figure 5B, the retainer 114, cooperating with hub 14, includes further predetermined portions 142 which are also used to define the damping control area. Still further portions of retainer 114, shown at 144, may be coated with the anti-wetting agent in order to confine the viscous liquid to the damping control area defined by shoulder surface 138 and the cooperating portions 142 of abutment 114.

It should be appreciated that the two embodiments shown in Figures 5A and 5B are not mutually exclusive and that the fluid coupling between the hub and the retainer shown in Figure 5B may be combined with the use of damping liquid to couple taut band 20 with hub 14.

As is apparent from comparison of Figures 5A and 5B, central tower 32 of hub 14 may be shortened to increase the acceptable range of vibration of the meter without pointer-bouncing and other adverse affects which occur when the tower bumps against the internal surfaces of retainer 114. Because such motions are damped by viscous liquid 130, the structure of Figure 5B may be provided with the shortened tower.

In yet a third embodiment of the invention, shown at Figure 5C, the viscous damping is provided between the permanent magnet and the coil frame. As particularly shown therein, a predetermined portion 146 of the horizontal support plate 66

forming the temperature compensating shunt for the magnet defines the damping control area. Further portions of the support plate, shown at 148, are coated with the anti-wetting agent to retain the viscous liquid within the desired damping control area. As will be noted from the figure, the predetermined portion 146 on the surface of the support plate of the permanent magnet assembly is offset by a circular notch 150 from the remainder of the surface of plate 66. The circular notch 150 is used to help define the shape of the drop of viscous liquid contacting the support plate. Although a circular notch is coined into the surface of the present embodiment, any shape may be so coined. The preferred circular notch is used to form a circular droplet and to define the drop diameter thereof. Inasmuch as the damping provided by the viscous liquid is a function of both the liquid viscosity and the coupling surface thereof, different degrees of damping may be provided by coining different sized notches into the support plate.

A predetermined portion 152 of the inner surface of coil frame 10 cooperates with portion 146 of the support plate of permanent magnet assembly 60 to define the damping control area in which the viscous liquid is intended to remain. Further portions of the inner surface of the frame 10 may also be coated with the anti-wetting agent in order to restrict the damping liquid to the desired area.

In order further to define the shape and location of the drop of damping liquid 130, coil frame 10 may include an offset portion 154. In order to retain the advantageous ease of manufacture of the frame component 10, offset portion 154 may be provided in an extrusion by longitudinal indentations on either side of the central internal surface thereof.

The viscous liquid provided in the embodiment of Figure 5C provides a fluid coupling between the permanent magnet assembly and the moving coil assembly for damping out vibrations therebetween. It should be noted that in the embodiment of Figure 5C the tower portion of hub 14 is shortened still further, to avoid the tower hitting the retainer in case of extreme vibration. The hub is thus provided with greater lateral freedom of movement. It is recognized that, in order to provide improved readability in situations of mechanical vibration, removal of lengthened portions of the tower may provide increased vulnerability of the taut band to vibration.

In all three embodiments of the invention, the viscosity of the damping liquid creates a damping effect for particular frequencies of vibration, whether of the taut band or of the moving coil assembly with respect to the permanent magnet assembly. The specific degree of damping may be varied by altering the quantity or viscosity of damping fluid utilized. Such variations, however, also affect the shock absorbing features of viscous oil 130. In a high-torque instrument damping may be increased both for the purpose of enhancing readability and for protection of the mechanism. In a low torque meter, however, where it may not be desirable to alter the meter response time, less viscous liquid may be used. In such an embodiment the taut band may required more protection, and accordingly a higher tower may be provided on the hub portion of the moving coil assembly. The embodiment of Figure 5A is particularly well-suited for such low torque meters, since the viscous liquid damps only the oscillations of the taut band and not the coupling of the stationary and moving assemblies. For higher torque meters, the embodiment of Figure 5C is preferred since it is easier to control the damping than in the embodiment of Figure 5B.

It should further be noted that although the embodiments shown in Figures 5A, B and C relate to the upper bridge support structure, substantially identical arrangements are provided for the bottom bridge portion 82 and hub 54, with respect to Figures 5A and 5B, and for the bottom support plate 68 and coil frame 10 for Figure 5C. As previously mentioned any combination of the foregoing embodiments may be used in order to provide damping tailored particularly to a desired environment.

The foregoing description of the preferred embodiment of the invention has been presented for purposes of illustration and description. It is not intended to be exhaustive or to limit the invention to the precise form disclosed, since many obvious modifications and variations are possible in light of the above teaching. The embodiment described was chosen in order best to explain the principles of the invention and its practical application, thereby to enable others skilled in the art best to utilize the invention in various embodiments and with various modifications as are best suited to the particular use contemplated. It is intended that the scope of the invention be defined by the claims appended hereto, when interpreted to obtain the full breadth to which they are fairly and legally entitled.

Claims

1. A moving coil permanent magnet mechanism for measuring electrical quantities, characterized by:

a moving coil wound about a flangeless support means;

a balance cross structure for providing balanced support for a pointer;

hub means for engaging said balance cross structure to said support means, said hub means including:

longitudinal indentations for engaging edges of a surface of said support means; and

extension portions dimensioned to prevent relative longitudinal movement between said hub means and said support means; and

torsional spring means connected to said balance cross structure for suspending an assembly of said hub means, said balance cross structure, and said support means.

2. The mechanism recited in claim 1 characterized in that said support means comprises a substantially rectangular extruded flangeless coil frame having substantially flat surfaces.

3. The mechanism recited in claim 1 or 2 characterized in that said hub means includes depending skirt means, including said longitudinal indentations, and assembly aid means including means for engaging a spreading tool, thereby to spread said longitudinal indentations for engaging said edges of said support means.

4. The mechanism recited in claim 1, 2 or 3 characterized by a pair of hub means, first and second bridge assemblies, and a counterbalance structure, said balance cross and counterbalance structures each including:

means for electrically connecting to opposite terminals of said coil wound on said support means;

means for attachment of said torsional spring means; and

means for engaging said hub means;

said hub means including passage structures for passage of said torsional spring means therethrough for connection to an appropriate one of said bridge assemblies.

5. The mechanism recited in claim 4 characterized in that said hubs each include cooperating means for receiving said engaging means of said balance, cross and counterbalance structures, and said passage structures comprising towers having axial passageways therein.

6. The mechanism recited in claim 4 or 5 characterized in that said first bridge assembly comprises:

tension spring means for engaging and applying tension to said torsional spring means; and

limit means for limiting rotation of the assembled hubs, coil support means, balance cross and counterbalance structures.

7. The mechanism as recited in claim 6 characterized in that said limit means comprises:

pairs of cooperating fingers depending from a surface of said first bridge assembly;

bead means for horizontally engaging said finger means to present an obstruction to a vertical portion of said balance cross structure; and

guide means for engaging said second bridge assembly.

8. The mechanism of claim 1 characterized by:

a magnet assembly having first and second vertical pole pieces and first and second horizontal support plates for forming a cage for insertion of a permanent magnet, said pole pieces including a vertical step on at least one horizontal surface thereof, for providing both a horizontal rest for one of said support plates and a vertical positioning structure therefor, thereby providing positioning means for said support plates and pole pieces with respect to each other;

first and second bridge assemblies wherein said first bridge assembly comprises means for engaging at least one upstanding projection of said second bridge assembly;

said support plates including notches for receiving said upstanding projection and for rotationally aligning said magnet assembly with respect to said bridge assemblies.

9. The mechanism recited in claim 8 characterized in that said upstanding projection of said second bridge assembly includes a shoulder for supporting a support plate of said magnet assembly, thereby vertically orienting said second bridge and said magnet assembly.

10. The mechanism recited in claim 9 characterized in that said upstanding projection includes a first locking tab for passage through a notch of at least one of said support plates, said locking tab being dimensioned to enable bending of the locking tab against said support plate, thereby locking said magnet assembly and said second bridge assembly together.

11. The mechanism recited in claim 10 characterized in that said means in said first bridge assembly for engaging said upstanding projection comprises a descending pair of parallel plates for guiding said projection, and an opening in said first bridge assembly for receiving said projection therein.

12. The mechanism recited in claim 11 characterized in that said upstanding projection includes a second locking tab for bendably engaging said opening in said first bridge assembly, thereby locking said first and second bridge assemblies and said magnet assembly together.

13. The mechanism recited in claim 12 characterized by yoke means for providing a magnetic path for the magnet in said magnet assembly, said yoke means having internal dimensions sufficiently large to form an air gap to permit movement of said coil support means between said magnet assembly and said yoke means, said yoke means further having an internal guiding groove for engaging said upstanding projection and for positioning the locked bridge and magnet assemblies against rotation therein.

14. The mechanism recited in claim 13 characterized in that said yoke means further includes in its upper surface a step dimensioned for receiving an upper support plate of said magnet assembly therein, thereby to permit said support plate upper surface to be positioned substantially evenly with the upper surface of said yoke means and for limiting the locked assemblies from further downward movement relative to said yoke means.

15. The mechanism recited in claim 14 characterized in that said upstanding projection further includes an inward step forming a lip for staking against a bottom surface of said yoke means, thereby to lock the yoke means to the combined first and second bridge assemblies and to the magnet assembly.

16. A mechanism having two relatively movable assemblies for metering electrical parameters, wherein a first assembly is connected to a second assembly by a torsional suspension means, said second assembly having a component rotationally movable with reference to said first assembly, characterized by:

viscous damping means for control of mechanical vibrations between said first and second assemblies, including a damping control area, defined by a predetermined portion of said component of said second assembly;

a viscous liquid contacting said predetermined portion of said component defining said damping control area; and

anti-wetting means provided on further portions of said component for retaining said viscous liquid in contact with, and preventing its spread from, said damping control area.

17. The mechanism recited in claim 16 characterized in that said component of said second assembly includes a passageway for said torsional suspension means, and said damping control area defined by said predetermined portion of said component is located within said passageway thereof;

said damping control area further including a segment of said torsional suspension means;

said anti-wetting means further provided on portions of said torsional suspension means for preventing spread of said viscous liquid to areas removed from said segment thereof and from said damping control area.

18. The mechanism recited in claim 16 or 17 characterized in that said first assembly comprises a permanent magnet assembly including a permanent magnet and a housing therefor, and tension spring means;

said second assembly comprises a moving coil assembly including a balance cross means;

said component of said second assembly comprises a hub structure having an interior surface defining said predetermined portion and said passageway therein; and

said torsional suspension means comprises a taut band connected to said balance cross means and to said tension spring means,

whereby said viscous liquid is retained within said passageway in contact with said taut band and said passageway.

19. The mechanism recited in claim 16 characterized in that said first assembly includes a movement limiting means for limiting relative linear movement between the two assemblies including cooperating component disposed adjacent to, and cooperating with, said component of said second assembly;

said cooperating component having a further predetermined portion adjacent said predetermined portion of said component of said second assembly;

said damping control area being defined by said predetermined portion of said component and by said further predetermined portion of said cooperating component.

20. The mechanism recited in claim 19 characterized in that said first assembly comprises a permanent magnet assembly including a permanent magnet and a housing therefor, said movement limiting means arranged for limiting vertical movement of said second assembly, and tension spring means;

said second assembly comprises a moving coil assembly including a balance cross means;

said component of said second assembly comprises a hub structure having said predetermined portion formed as a surface thereof; and

said torsional suspension means comprises a taut band connected to said balance cross means and to said tension spring means;

said cooperating component is included in said movement limiting means and has said further predetermined portion formed as a surface thereof opposing said surface forming said predetermined portion of said hub portion;

said anti-wetting means is further provided on portions of the cooperating component removed from said surface forming said further predetermined portion thereof defining said damping control area,

whereby said viscous liquid is retained between said hub surface and said opposing surface of said movement limiting means.

21. The mechanism recited in claim 16 characterized in that said first assembly comprises a permanent magnet assembly having a permanent magnet and a housing therefor;

said second assembly component comprises a frame for a coil wound thereon;

said damping control area is defined by a predetermined portion of a surface of said permanent magnet housing and by a predetermined portion of a surface of said frame opposing said predetermined portion of said magnet housing surface; and

said anti-wetting means in provided on further portions of said permanent magnet housing surface and of said frame surface for retaining said viscous liquid within said damping control area.

22. The mechanism recited in claim 21 characterized in that said viscous damping means further comprises offset means formed in said predetermined portion   said permanent magnet housing surface for shaping a quantity of said viscous liquid to form a drop contacting said predetermined portions of said premanent magnet housing surface and said frame surface.

23. The mechanism recited in claim 21 or 22 characterized in that said predetermined portion of said frame surface comprises an offset portion for shaping a quantity of said viscous liquid to form a drop in contact with said predetermined portions of said permanent magnet housing surface and said frame surface.

0098780

- 26 -

24. The mechanism recited in claim 21, 22 or 23 characterized in that said permanent magnet housing includes a horizontal support connecting a pair of vertical pole pieces, said horizontal support having a surface including said predetermined portion of a surface of said permanent magnet assembly defining said damping control area.

25. A method for temperature compensation of the permanent magnet of a moving coil meter mechanism having a permanent magnet, pole pieces arranged for forming a housing for said permanent magnet, a yoke structure, and a wound coil movable in an air gap formed between the pole pieces and the yoke structure, said method being characterized by the steps of:

(a) determining a magnetic flux density to be established within said air gap for linking said movable wound coil;

(b) establishing limits for acceptable variation of said flux density within said air gap for a predetermined temperature range; and

(c) reducing variations in said flux density within said air gap to be within the established limits for the predetermined temperature range, including the step of placing an appropriately dimensioned compensating shunt, formed of material having a temperature dependent permeability, adjacent and parallel to said permanent magnet.

26. The method recited in claim 25 characterized in that said placing step comprises the further steps of:

calculating a thickness for said shunt sufficient to reduce said flux variations to the acceptable limits established therefor; and

placing a compensating shunt having the calculated thickness adjacent and parallel to said permanent magnet.

27. The method recited in claim 26 characterized in that said step of placing said compensating shunt comprises the step of forming a housing for said magnet by interposing said compensating shunt between said pole pieces.

28. The method recited in claim 25 characterized in that said placing step further comprises the steps of:

calculating a thickness for said shunt sufficient to reduce said flux variations to the acceptable limits established therefor; and

placing two shunts having a combined thickness commensurate with said calculated thickness adjacent and parallel to said permanent magnet.

29. The method recited in claim 28 characterized in that said permanent magnet includes surfaces associated with said pole pieces and first and second oppositely disposed planar sides, and said step of placing two shunts comprises the steps of:

placing one of said two shunts adjacent and parallel to one of said oppositely disposed planar sides; and

placing the other of said two shunts adjacent and parallel to the other of said oppositely disposed planar sides.

30. The method recited in any one of claims 25-29 characterized by the further step of choosing a ceramic magnet for use as said permanent magnet in said meter mechanism.

31. The method recited in claim 30 characterized by the further step of calibrating said meter mechanism, wherein said step of calibrating comprises the steps of charging and treating said ceramic magnet.

32. A moving coil meter mechanism having a permanent magnet, pole pieces arranged for forming a housing for said permanent magnet, a yoke structure and a wound coil movable in an air gap formed between the pole pieces and the yoke structure, the meter mechanism including means for providing compensation for variations in flux density within said air gap caused by temperature changes, characterized by:

compensating shunt means formed of material having a temperature variable permeability, said compensating shunt means being positioned adjacent and parallel to said permanent magnet and having a thickness selected for reducing the temperature caused variations in flux density within said air gap to predetermined acceptable limits.

0098780

- 28 -

33. The mechanism recited in claim 32 characterized in that said compensating shunt means comprises a plate formed of said material having a temperature variable permeability and further having said selected thickness.

34. The mechanism recited in claim 32 characterized in that said compensating shunt comprises two plates formed of said material having a temperature variable permeability and having a combined thickness commensurate with said selected thickness.

35. The mechanism recited in claim 34 characterized in that said permanent magnet includes surfaces associated with said pole pieces, first and second oppositely disposed planar sides, and wherein one of said two plates is positioned adjacent and parallel to one of said oppositely disposed planar sides, and the other of said two plates is positioned adjacent and parallel to the other of said oppositely disposed planar sides.

36. The mechanism recited in claim 33 or 35 characterized in that said compensating shunt is formed as a horizontal support plate between vertically disposed pole pieces forming said housing for said permanent magnet.

37. The mechanism as recited in any one of claims 32-36 characterized in that the material having a temperature variable permeability is formed of an alloy of nickel and iron.

38. The mechanism as recited in any one of claims 1-24, 32-37 characterized in that said permanent magnet comprises a ceramic magnet material.

1/3

FIG.1

FIG.3A

FIG.3B

FIG.4

FIG. 2

FIG. 5A

FIG. 5B

FIG. 5C